# FASCICULE DE BREVET EUROPEEN

(11) **EP 2 987 167 B1**
(45) Date de publication et mention de la délivrance du brevet: **06.03.2019**
(21) Numéro de dépôt: 14722275.6
(22) Date de dépôt: 15.04.2014
(51) Int. Cl.: G11C 14/00, G11C 11/16, G11C 13/00

(54) **CELLULE MEMOIRE NON-VOLATILE**
NICHTFLÜCHTIGER SPEICHER
NON-VOLATILE MEMORY CELL

(30) Priorité: 15.04.2013 FR 1353397
(43) Date de publication de la demande: 24.02.2016
(73) Titulaire: COMMISSARIAT À L'ÉNERGIE ATOMIQUE ET AUX ÉNERGIES ALTERNATIVES, 75015 Paris (FR); Centre National de la Recherche Scientifique, 75794 Paris Cedex 16 (FR)
(72) Inventeur: PRENAT, Guillaume, F-38120 Saint-Egrève (FR); DI PENDINA, Grégory, F-38130 Echirolles (FR)
(74) Mandataire: Cabinet Beaumont
(86) Numéro de dépôt international: PCT/FR2014/050912
(87) Numéro de publication internationale: WO 2014/170593

(56) Documents cités:
- FR-A1- 2 970 589
- FR-A1- 2 970 590
- US-A1- 2011 122 709
- US-A1- 2012 320 658
- YOUNGDON JUNG ET AL: "MTJ based non-volatile flip-flop in deep submicron technology", SOC DESIGN CONFERENCE (ISOCC), 2011 INTERNATIONAL, IEEE, 17 novembre 2011 (2011-11-17), pages 424-427, XP032101617, DOI: 10.1109/ISOCC.2011.6138622 ISBN: 978-1-4577-0709-4

## Description

La présente demande de brevet revendique la priorité de la demande de brevet français FR13/53397.

### Domaine

La présente description concerne une cellule mémoire et un procédé de mémorisation non volatile d'une valeur de données dans une cellule mémoire. En particulier, la présente description concerne une cellule mémoire et un procédé comprenant un ou plusieurs éléments résistifs pouvant être programmés par la direction d'un courant.

### Arrière-plan

Il a déjà été proposé d'utiliser des éléments résistifs programmables dans des cellules mémoires pour assurer une mémorisation de données non volatile. De tels éléments résistifs sont programmables pour prendre l'un d'une pluralité d'états résistifs différents. L'état résistif programmé est maintenu même lorsque la tension d'alimentation de la cellule mémoire est déconnectée, et par conséquent des données peuvent être mémorisées par de tels éléments d'une manière non volatile.

Divers types d'éléments résistifs ont été proposés, certains d'entre eux pouvant être programmés par la direction d'un courant qu'on fait passer dans les éléments résistifs. Un exemple d'un tel élément résistif programmable par un courant est un élément STT (couple de transfert de spin), qui est basé sur des jonctions tunnel magnétiques (MTJ).

En raison au moins en partie des transistors utilisés pour programmer les états résistifs, des cellules mémoires basées sur des éléments résistifs programmables ont tendance à être moins compactes que d'autres types de cellules mémoires comme celles d'une mémoire RAM (mémoire à accès aléatoire). On a de façon générale besoin dans la technique d'une cellule mémoire basée sur des éléments résistifs programmables ayant une surface réduite.

La demande de brevet US publiée sous le numéro US 2011/0122706 concerne un circuit de bascule non-volatile.

### RESUME

Un objet de modes de réalisation de la présente description est de résoudre au moins partiellement un ou plusieurs besoins de l'art antérieur.

Selon un aspect, on prévoit une cellule mémoire comprenant : des premier et deuxième éléments résistifs, au moins l'un d'eux étant programmable pour prendre l'un d'au moins deux états résistifs, une valeur de donnée étant représentée par les résistances relatives des premier et deuxième éléments résistifs, le premier élément résistif étant couplé entre un premier noeud de mémorisation et un premier noeud intermédiaire, le deuxième élément résistif étant couplé entre un deuxième noeud de mémorisation et un deuxième noeud intermédiaire ; un premier transistor couplé entre le premier noeud de mémorisation et une première tension d'alimentation ; un deuxième transistor couplé entre le deuxième noeud de mémorisation et la première tension d'alimentation, un noeud de commande du premier transistor étant couplé au deuxième noeud de mémorisation et un noeud de commande du deuxième transistor étant couplé au premier noeud de mémorisation ; un troisième transistor couplé entre les premier et deuxième noeuds intermédiaires ; un quatrième transistor connecté entre le premier noeud de mémorisation et une deuxième tension d'alimentation ; un cinquième transistor connecté entre le deuxième noeud de mémorisation et la deuxième tension d'alimentation ; et un circuit de commande agencé pour activer le troisième transistor pendant l'application, par l'activation du quatrième ou cinquième transistor, de la deuxième tension d'alimentation au premier ou au deuxième noeud de mémorisation pour générer un courant de programmation dans une direction sélectionnée à travers les premier et deuxième éléments résistifs pour programmer l'état résistif d'au moins l'un desdits éléments.

Selon un mode de réalisation, chacun des premier et deuxième transistors est connecté à la première tension d'alimentation.

Selon un mode de réalisation, au moins l'un des premier et deuxième éléments résistifs est l'un des éléments suivants : un élément à couple de transfert de spin ayant une anisotropie dans le plan ; un élément à couple de transfert de spin ayant une anisotropie perpendiculaire au plan ; un élément à oxydoréduction (RedOx) ; un élément ferroélectrique ; et un élément à changement de phase.

Selon un mode de réalisation, chacun des premier et deuxième transistors comprend un noeud de substrat, et le circuit de commande est en outre agencé pour coupler le noeud de substrat d'au moins l'un des premier et deuxième transistors à la premier tension d'alimentation et le noeud de substrat de l'autre des premier et deuxième transistors à une troisième tension d'alimentation, différente de la première tension d'alimentation et par exemple égale à la deuxième tension d'alimentation, pendant l'application de la deuxième tension d'alimentation au premier ou au deuxième noeud de mémorisation.

Selon un mode de réalisation, la cellule mémoire comprend en outre : un sixième transistor couplé entre le premier noeud intermédiaire et la deuxième tension d'alimentation ; et un septième transistor couplé entre le deuxième noeud intermédiaire et la deuxième tension d'alimentation, le circuit de commande étant en outre agencé pour transférer la valeur de donnée représentée par les états résistifs des premier et deuxième éléments résistifs vers les premier et deuxième noeuds de mémorisation en activant les sixième et septième transistors.

Selon un mode de réalisation, les quatrième et cinquième transistors et/ou les sixième et septième transistors sont adaptés à avoir une tension de seuil inférieure à celle des premier et deuxième transistors.

Selon un autre aspect, on prévoit un dispositif mémoire comprenant un réseau de cellules mémoires susmentionnées. Dans un exemple, les premiers noeuds de mémorisation des cellules mémoires sont par exemple couplés à des premières lignes de bit du dispositif mémoire et les deuxièmes noeuds de mémorisation des cellules mémoires sont par exemple couplés à des deuxièmes lignes de bit du dispositif mémoire. Dans un autre exemple, le premier noeud de mémorisation de chacune des cellules mémoires est couplé à l'une correspondante des premières lignes de bit par l'intermédiaire d'un huitième transistor, et le deuxième noeud de mémorisation de chacune des cellules mémoires est couplé à l'une correspondante des deuxièmes lignes de bit par l'intermédiaire d'un neuvième transistor.

Selon un autre aspect, on prévoit un dispositif mémoire synchrone comprenant la cellule mémoire susmentionnée ; et une autre cellule mémoire couplée en série avec ladite cellule mémoire par l'intermédiaire d'un dixième transistor, l'autre cellule mémoire comprenant deux inverseurs couplés de façon croisée.

Selon encore un autre aspect, on prévoit un procédé de mémorisation non volatile d'une valeur de donnée dans une cellule mémoire, la cellule mémoire comprenant : des premier et deuxième éléments résistifs dont au moins l'un est programmable pour prendre l'un d'au moins deux états résistifs, le premier élément résistif étant couplé entre un premier noeud de mémorisation et un premier noeud intermédiaire, le deuxième élément résistif étant couplé entre un deuxième noeud de mémorisation et un deuxième noeud intermédiaire ; un premier transistor couplé entre le premier noeud de mémorisation et une première tension d'alimentation ; un deuxième transistor couplé entre le deuxième noeud de mémorisation et la première tension d'alimentation, un noeud de commande du premier transistor étant couplé au deuxième noeud de mémorisation et un noeud de commande du deuxième transistor étant couplé au premier noeud de mémorisation ; un troisième transistor couplé entre les premier et deuxième noeuds intermédiaires ; un quatrième transistor connecté entre le premier noeud de mémorisation et une deuxième tension d'alimentation ; et un cinquième transistor connecté entre le deuxième noeud de mémorisation et la deuxième tension d'alimentation ; le procédé comprenant : activer le troisième transistor ; appliquer la deuxième tension d'alimentation, par l'activation du quatrième ou cinquième transistor, au premier ou au deuxième noeud de mémorisation pendant que le troisième transistor est activé pour générer un courant de programmation dans une direction sélectionnée à travers les premier et deuxième éléments résistifs pour programmer l'état résistif d'au moins l'un des éléments, la valeur de donnée étant représentée par les résistances relatives des premier et deuxième éléments résistifs.

### BRÈVE DESCRIPTION DES DESSINS

Les caractéristiques et avantages susmentionnés, et d'autres, apparaîtront clairement avec la description détaillée suivante de modes de réalisation, donnés à titre illustratif et non limitatif, en référence aux dessins joints, dans lesquels :
la figure 1 illustre schématiquement une cellule mémoire qui a été proposée ;
la figure 2 illustre schématiquement une cellule mémoire selon un exemple de réalisation de la présente description ;
les figures 3A et 3B sont des chronogrammes représentant des signaux dans le circuit de la figure 2 pendant une phase de transfert de données selon un exemple de réalisation de la présente description ;
les figures 4A et 4B sont des chronogrammes représentant des signaux dans le circuit de la figure 2 pendant une phase d'écriture selon un mode de réalisation de la présente description ;
la figure 5 illustre schématiquement une cellule mémoire selon un autre exemple de réalisation de la présente description ;
les figures 6A et 6B sont des chronogrammes représentant des signaux dans la cellule mémoire de la figure 5 pendant une phase d'écriture selon un exemple de réalisation de la présente description ;
les figures 7A et 7B illustrent des éléments résistifs basés sur des jonctions tunnel magnétiques selon un exemple de réalisation de la présente description ;
la figure 8 illustre schématiquement une cellule mémoire selon un autre exemple de réalisation de la présente description ;
la figure 9 illustre schématiquement un dispositif mémoire synchrone selon un exemple de réalisation de la présente description ; et
la figure 10 illustre schématiquement un réseau mémoire selon un exemple de réalisation de la présente description.

### DESCRIPTION DÉTAILLÉE

Dans la description suivante, le terme "connecté" est utilisé pour désigner une connexion directe entre un élément et un autre, tandis que le terme "couplé" implique que la connexion entre les deux éléments peut être faite directement, ou via un élément intermédiaire, comme un transistor, une résistance ou un autre composant.

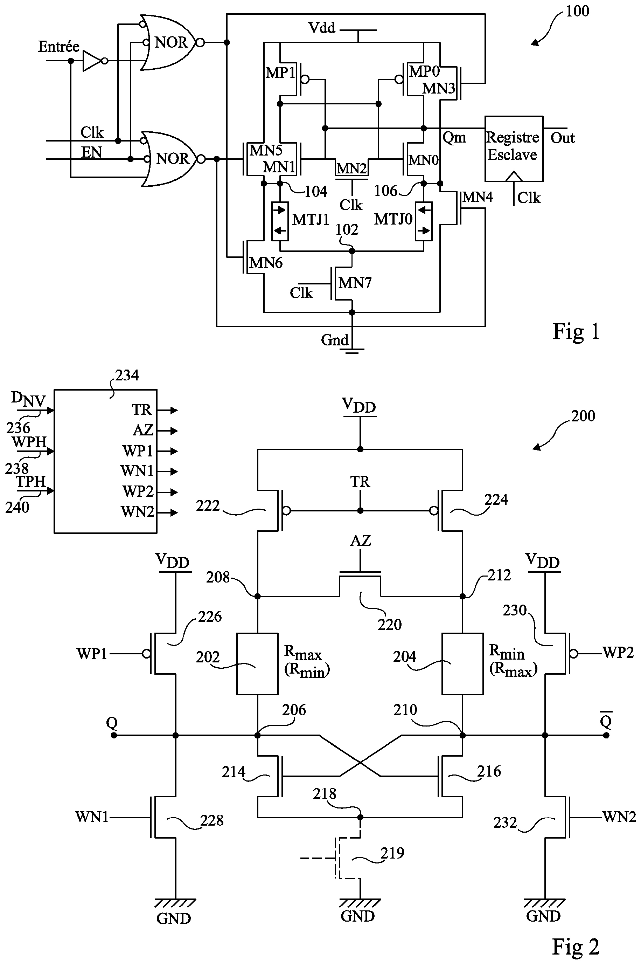

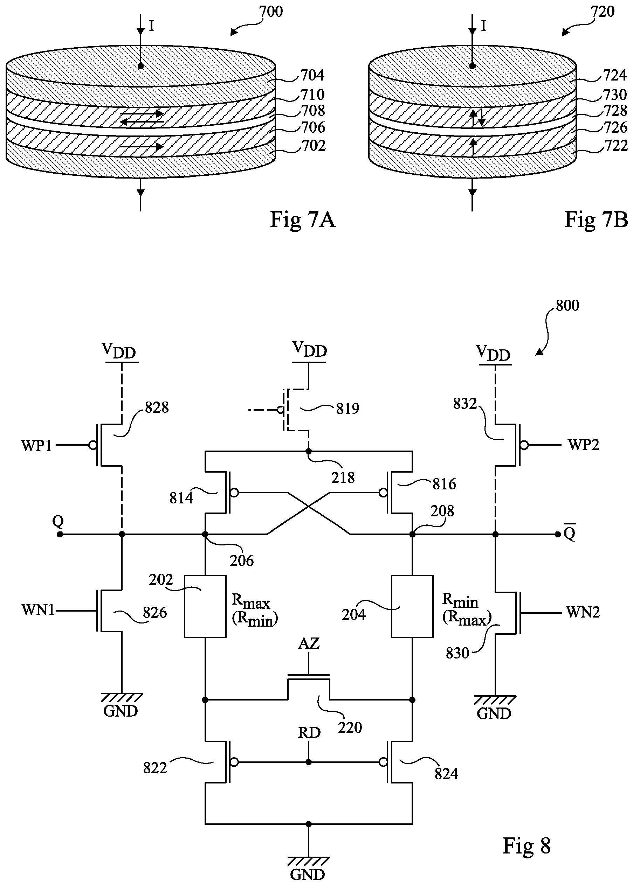

La figure 1 reproduit sensiblement la figure 7 de la publication intitulée "Spin-MTJ based Non volatile Flip-Flop", Weisheng Zhao et al., Proceedings of the 7th IEEE International Conférence on Nanotechnology August 2-5, 2007, Hong-Kong.

La bascule 100 représentée en figure 1 comprend un registre maître et un registre esclave. Le registre maître comprend des dispositifs à jonction tunnel magnétique MTJ1 et MTJO, programmables par un courant. Le dispositif MTJ1 est connecté entre un noeud intermédiaire 104 et un noeud d'interconnexion 102. Le dispositif MTJ0 est connecté entre un noeud intermédiaire 106 et le noeud d'interconnexion 102. Le noeud d'interconnexion 102 connecte entre eux les dispositifs MTJ MTJ0 et MTJ1. Le noeud intermédiaire 104 est en outre couplé à une tension d'alimentation Vdd par l'intermédiaire de deux transistors MN1 et MP1 couplés en série et formant un premier inverseur. Le noeud intermédiaire 106 est en outre couplé à la tension d'alimentation Vdd par l'intermédiaire de deux transistors MP0 et MN0 couplés en série et formant un deuxième inverseur. Les premier et deuxième inverseurs sont couplés de façon croisée entre eux, et la sortie du deuxième inverseur est connectée au registre esclave. Un transistor MN2 est couplé entre les noeuds de grille des transistors MN1 et MN0.

Un transistor MN5 est couplé entre le noeud intermédiaire 104 et la tension d'alimentation Vdd, et un transistor MN6 est couplé entre le noeud intermédiaire 104 et la masse. En outre, un transistor MN3 est couplé entre le noeud intermédiaire 106 et la tension d'alimentation Vdd, et un transistor MN4 est couplé entre le noeud intermédiaire 106 et la masse. Un transistor MN7 est couplé entre le noeud intermédiaire 102 et la masse. Les transistors MN3 à MN6 permettent le passage d'un courant dans les éléments résistifs MTJ1 et MTJ0 dans une direction ou dans l'autre afin de programmer les états résistifs des dispositifs MTJ. Pendant cette phase de programmation, le transistor MN7 est utilisé pour déconnecter le noeud 102 de la masse. Une paire de portes NOR et un inverseur sur le côté gauche de la figure 1, qui sont contrôlés par un signal d'entrée, un signal d'horloge Clk et un signal d'activation EN, génèrent des signaux pour contrôler les transistors MN3 à MN6.

Un inconvénient du circuit de la figure 1 est que le registre maître comprend un total de 10 transistors, sans tenir compte de ceux des portes NOR et de l'inverseur.

La figure 2 illustre une cellule mémoire 200 selon un exemple de réalisation de la présente description.

La cellule mémoire 200 comprend des éléments résistifs 202 et 204, chacun d'eux pouvant être programmé pour prendre l'un d'une pluralité d'états résistifs. Les éléments résistifs 202 et 204 peuvent être d'un type quelconque d'élément à commutation de résistance pour lequel la résistance est programmable par la direction d'un courant qu'on fait passer dedans. Par exemple, comme on va le décrire plus en détail dans la suite en référence aux figures 7A et 7B, les éléments à commutation de résistance 202, 204 sont des éléments à couple de transfert de spin ayant une anisotropie dans le plan ou perpendiculaire au plan, comme cela est décrit plus en détail dans la publication intitulée "Magnonic spin-transfer torque MRAM with low power, high speed, and error-free switching", N. Mojumder et al., IEDM Tech. Digest (2010), et dans la publication intitulée "Electric toggling of magnets", E. Tsymbal, Natural Materials Vol 11, January 2012. A titre de variante, les éléments résistifs pourraient être ceux utilisés dans des mémoires à commutation de résistance RAM de type RedOx (RAM à oxydoréduction), qui sont par exemple décrites plus en détail dans la publication intitulée "Redox-Based Resistive Switching Memories - Nanoionic Mechanisms, Prospects and Challenges", Rainer Waser et al., Advanced Materials 2009, 21, pages 2632 à 2663. Dans encore un autre exemple, les éléments résistifs pourraient être ceux utilisés dans des mémoires de type FeRAM (RAM ferroélectriques) ou des PCRAM (RAM à changement de phase).

Quel que soit le type d'élément résistif, un bit de donnée est par exemple mémorisé dans la cellule mémoire de façon non volatile en mettant l'un des éléments à une résistance relativement élevée (Rₘₐₓ), et l'autre à une résistance relativement basse (Rₘᵢₙ). Dans l'exemple de la figure 2, l'élément 202 est programmé pour avoir une résistance Rₘₐₓ et l'élément 204 une résistance Rₘᵢₙ représentant une valeur du bit de donnée, et comme cela est représenté par les références Rₘᵢₙ et Rₘₐₓ entre parenthèses, une programmation opposée des valeurs de résistance mémorise la valeur opposée du bit de donnée. Chacun des éléments à commutation de résistance 202, 204 a par exemple seulement deux états résistifs correspondant aux résistances haute et basse Rₘₐₓ et Rₘᵢₙ, mais les valeurs exactes de Rₘᵢₙ et Rₘₐₓ peuvent varier en fonction de conditions telles que le procédé, les matériaux, les variations de température, etc.

Le bit de donnée non volatile représenté par les éléments résistifs 202, 204 dépend duquel des éléments résistifs a la résistance Rₘₐₓ ou Rₘᵢₙ, en d'autres termes, dépend des résistances relatives. Les éléments résistifs 202, 204 sont par exemple sélectionnés de telle sorte que Rₘₐₓ soit toujours notablement supérieure à Rₘᵢₙ, par exemple supérieure d'au moins 20 pourcent. En général, le rapport entre la résistance Rₘₐₓ et la résistance Rₘᵢₙ est par exemple compris entre 1,2 et 10000. Rₘᵢₙ est par exemple dans la région des 2 kilo-ohms ou moins, et Rₘₐₓ est par exemple dans la région des 6 kilo-ohms ou plus, bien que d'autres valeurs soient possibles.

Il sera clair pour l'homme de l'art que dans certains modes de réalisation, plutôt que les deux éléments résistifs 202, 204 soient programmables, un seul soit programmable. Dans un tel cas, l'autre élément résistif a par exemple une résistance fixe à un niveau intermédiaire environ à mi-chemin entre Rₘᵢₙ et Rₘₐₓ, par exemple égal avec une tolérance de 10 pourcent, à (Rₘᵢₙ+(Rₘₐₓ-Rₘᵢₙ)/2). Par exemple, l'un des éléments résistifs 202, 204 pourrait correspondre à une résistance de valeur fixe. A titre de variante, l'un des éléments résistifs 202, 204 pourrait être constitué de deux éléments résistifs programmables couplés en parallèle et ayant des orientations opposées, de sorte quel que soit le sens dans lequel chaque élément est programmé, la valeur de résistance reste relativement constante au niveau intermédiaire.

L'élément résistif 202 est couplé entre un noeud de mémorisation 206 et un noeud intermédiaire 208. L'élément résistif 204 est couplé entre un noeud de mémorisation 210 et un noeud intermédiaire 212. Les noeuds de mémorisation 206 et 210 mémorisent des tensions Q et *Q̅* respectivement. Deux inverseurs sont couplés de façon croisée entre les noeuds de mémorisation 206 et 210 pour former un registre. Chaque inverseur est constitué d'un seul transistor 214, 216 respectivement. Le transistor 214 est par exemple un transistor MOS à canal N (NMOS) couplé par ses noeuds de courant principaux entre le noeud 206 et un autre noeud 218. Le transistor 216 est par exemple un transistor NMOS couplé par ses noeuds de courant principaux entre le noeud de mémorisation 210 et l'autre noeud 218. Un noeud de commande du transistor 214 est couplé au noeud de mémorisation 210, et un noeud de commande du transistor 216 est couplé au noeud de mémorisation 206. Le noeud 218 est soit connecté à la masse, soit couplé à la masse par l'intermédiaire des noeuds de courant principaux d'un transistor NMOS 219, représenté par des lignes en pointillés en figure 2.

Les noeuds intermédiaires 208 et 212 sont couplés entre eux par l'intermédiaire des noeuds de courant principaux d'un transistor NMOS 220. Le transistor 220 reçoit sur son noeud de commande un signal AZ décrit plus en détail ci-après.

Le noeud 208 est en outre couplé à une tension d'alimentation V_{DD} par l'intermédiaire des noeuds de courant principaux d'un transistor MOS à canal P (PMOS) 222. De façon similaire, le noeud 212 est couplé à la tension d'alimentation V_{DD} par l'intermédiaire des noeuds de courant principaux d'un transistor PMOS 224. Les noeuds de commande des transistors PMOS 222 et 224 sont couplés ensemble à un signal de transfert TR décrit plus en détail ci-après.

Le noeud de mémorisation 206 est en outre couplé à la tension d'alimentation V_{DD} par l'intermédiaire des noeuds de courant principaux d'un transistor PMOS 226, et à la masse par l'intermédiaire des noeuds de courant principaux d'un transistor NMOS 228. Les transistors 226 et 228 reçoivent sur leurs noeuds de commande des signaux d'écriture WP1 et WN1 respectivement. De façon similaire, le noeud de mémorisation 210 est couplé à la tension d'alimentation V_{DD} par l'intermédiaire des noeuds de courant principaux d'un transistor PMOS 230, et à la masse par l'intermédiaire des noeuds de courant principaux d'un transistor NMOS 232. Les transistors 230 et 232 reçoivent sur leurs noeuds de commande des signaux d'écriture WP2 et WN2 respectivement.

La figure 2 illustre aussi un bloc de commande 234, fournissant les signaux de commande TR, AZ, WP1, MN1, WP2 et WN2 allant vers les transistors correspondants de la cellule mémoire 200. Comme cela est illustré, ces signaux de commande sont par exemple générés sur la base de données non volatiles D_{NV} reçues sur une ligne d'entrée 236, d'un signal de phase d'écriture WPH reçu sur une ligne d'entrée 238, et d'un signal de phase de transfert TPH reçu sur une ligne d'entrée 240.

Dans la bascule 100 de la figure 1, les transistors MP1 et MP0 sont couplés au rail d'alimentation Vdd et ont pour rôle de maintenir un état haut sur l'un des noeuds du registre formé par les quatre transistors MN0, MN1, MP0 et MP1. Dans la cellule 200 de la figure 2, dans laquelle chaque inverseur est mis en oeuvre par un seul transistor 214, 216, l'état haut de Q ou *Q̅* est maintenu par un courant de fuite passant dans les transistors PMOS 222 ou 224, et/ou dans les transistors PMOS 226 et 230.

Les tensions de seuil des transistors PMOS 222, 224 et/ou 226, 230 sont choisies de façon à être inférieures à celles des transistors NMOS 214, 216, 228, 232 de sorte que lorsqu'ils sont dans l'état non conducteur, le courant de fuite dans les transistors 222, 224 et/ou 226, 230 est supérieur à celui dans les transistors 214, 216, 228, 232, maintenant ainsi le noeud correspondant 206 ou 210 à une tension suffisamment haute pour être vue comme un état logique haut. En d'autres termes, le courant de fuite I_{offP} passant dans le transistor PMOS 222, 224 et/ou 226, 230 lorsqu'une tension de niveau haut est appliquée aux noeuds de grille correspondants est supérieur au courant de fuite I_{offN} passant dans le transistor NMOS correspondant 214, 216, 228 ou 232 lorsqu'une tension de niveau bas est appliquée sur son noeud de grille.

Les tensions de seuil particulières vont dépendre de la technologie utilisée. A titre d'exemple, les tensions de seuil des transistors PMOS 222, 224, et/ou 226, 230 sont choisies de façon à être dans la plage de 0,3 à 0,5 V, alors que les tensions de seuil des transistors NMOS 214, 216, 228, 232 sont la plage de 0,4 à 0,6 V. Dans tous les cas, le rapport I_{0ffp}/I_{Offn} est sélectionné par exemple pour être supérieur à 25, et de préférence supérieur à 100.

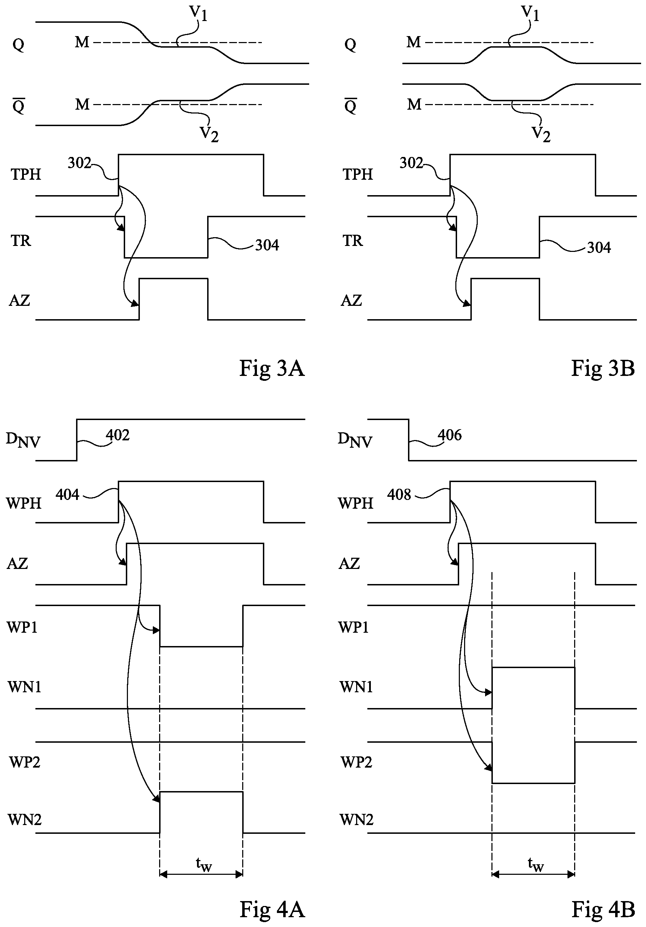

On va maintenant décrire plus en détail le fonctionnement du circuit de la figure 2 en faisant référence aux figures 3A et 3B, et 4A et 4B.

D'abord, on notera que, contrairement à la bascule de la figure 1, la cellule mémoire 200 est capable de mémoriser, de façon volatile, un bit de donnée qui est indépendant des états résistifs programmés des éléments 202 et 204. En effet, le registre formé par les transistors 214 et 216 va conserver tout état mémorisé.

Les figures 3A et 3B sont des chronogrammes représentant des signaux dans la cellule mémoire de la figure 2 pendant une phase de transfert. En particulier, les figures 3A et 3B illustrent les signaux de données Q et *Q̅* présents sur les noeuds de mémorisation 206 et 210, le signal de phase de transfert TPH, le signal de transfert TR, et le signal AZ pendant une phase de transfert du circuit.

La phase de transfert correspond à une opération consistant à transférer la donnée représentée par les états résistifs programmés des éléments résistifs 202 et 204 vers les noeuds de mémorisation 206, 210. Ainsi, la donnée est transformée d'une représentation par l'état résistif programmé en une représentation par des niveaux de tension sur les noeuds de mémorisation 206 et 210.

Ainsi, la phase de transfert implique d'établir les niveaux des tensions Q et *Q̅* sur les noeuds de mémorisation 206 et 210 sur la base des états résistifs programmés. Dans les exemples des figures 3A et 3B, on suppose que l'élément résistif 202 a été programmé de façon à avoir une résistance élevée Rₘₐₓ, et l'élément résistif 204 une résistance basse Rₘᵢₙ. Bien que cela ne soit pas représenté dans les figures 3A et 3B, pendant la phase de transfert, les signaux de commande WP1, WP2 sont hauts et les signaux de commande WN1, WN2 sont bas de telle sorte que les transistors correspondants 226 à 232 sont tous non conducteurs.

La figure 3A correspond à un cas dans lequel les tensions Q et *Q̅* sont initialement à un état haut et à un état bas respectivement. Le terme "état haut" est utilisé ici pour désigner un niveau de tension proche ou égal au niveau de la tension d'alimentation V_{DD}, tandis que le terme "état bas" est utilisé ici pour désigner un niveau de tension proche ou égal à la tension de masse.

Le signal de transfert TR est par exemple initialement haut, de sorte que les transistors 222 et 224 sont non-conducteurs. Le signal AZ est par exemple initialement bas, de sorte que le transistor 220 est non conducteur.

Le signal de phase de transfert TPH, qui est par exemple initialement bas, est activé comme cela est représenté par un front montant 302, déclenchant peu de temps après un front descendant du signal de transfert TR, et un front montant du signal AZ, par exemple peu de temps après le front descendant du signal de transfert TR. Ainsi, les transistors 220, 222 et 224 de la figure 2 sont tous activés, induisant un courant dans la branche de gauche de la cellule mémoire 200 qui passe dans le transistor 222, dans l'élément résistif 202 et le transistor 214, et un courant dans la branche de droite de la cellule mémoire qui passe dans le transistor 224, dans l'élément résistif 204 et le transistor 216.

Toutefois, en raison de la différence entre les résistances des éléments résistifs 202 et 204, le courant dans la branche de gauche est inférieur au courant dans la branche de droite. Ainsi, ces courants par exemple provoquent la descente de la tension sur le noeud de mémorisation 206 et son établissement à un niveau V₁ inférieur à un niveau de métastabilité M, et la montée de la tension sur le noeud de mémorisation 210 jusqu'à un niveau V₂ supérieur au niveau de métastabilité M. Le niveau de métastabilité M est un niveau de tension théorique situé environ à mi-chemin entre les états de tension haut et bas, représentant le niveau à partir duquel il y aurait une probabilité égale que Q bascule vers l'état haut ou vers l'état bas. L'activation du signal AZ pour rendre conducteur le transistor 220 a pour effet d'accélérer la descente du niveau de tension Q, et la montée du niveau de tension *Q̅*.

Le signal AZ est ensuite amené à l'état bas, et le signal de transfert TR est amené de nouveau à l'état haut sur un front montant 304, de sorte que les niveaux Q et *Q̅* vont vers leur état stable le plus proche, qui dans l'exemple de la figure 3A correspond à l'état Q bas, *Q̅* haut. Toutefois, il sera clair pour l'homme de l'art que les niveaux V₁ et V₂, et l'état stable final, vont dépendre de facteurs tels que la résistance à l'état conducteur des transistors 214, 216, 222 et 224. Finalement, le signal de phase de transfert TPH, passe à l'état bas pour achever la phase de transfert.

La figure 3B correspond à un cas dans lequel les tensions Q et *Q̅* sont initialement à un état bas et un état haut respectivement. Le signal de phase de transfert TPH, le signal de transfert TR et le signal AZ ont les mêmes formes que celles de la figure 3A et ne vont pas être décrits de nouveau. La différence par rapport à la figure 3A est que, lorsque le signal TR est amené à l'état bas et le signal AZ est amené à l'état haut, la tension Q monte vers le niveau V₁, et la tension *Q̅* descend vers le niveau V₂. Après cela, les niveaux Q et *Q̅* vont vers leur état stable le plus proche, qui dans l'exemple de la figure 3B correspond à l'état Q bas et *Q̅* haut. Toutefois, ici encore il sera clair pour l'homme de l'art que les niveaux V₁ et V₂, et l'état stable final, vont dépendre de facteurs tels que les résistances à l'état conducteur des transistors 214, 216, 222 et 224.

Les figures 4A et 4B sont des chronogrammes illustrant des exemples des signaux D_{NV}, WPH, AZ, WP1, WN1, WP2 et WN2 dans le circuit de la figure 2 pendant une phase d'écriture des états résistifs des éléments résistifs 202 et 204. Bien que cela ne soit pas représenté dans les figures 4A et 4B, pendant la phase d'écriture, le signal de transfert TR par exemple reste haut de sorte que les transistors 222 et 224 sont non conducteurs.

La phase d'écriture implique le passage d'un courant dans chacun des éléments résistifs 202, 204 par l'intermédiaire du transistor 220, soit dans la direction allant du noeud de mémorisation 206 vers le noeud de mémorisation 210, soit dans la direction opposée. Les éléments résistifs 202 et 204 sont orientés de telle sorte que, pour une direction donnée du courant, ils vont être programmés de façon à avoir des résistances opposées. En particulier, chaque élément résistif 202, 204 peut être orienté dans l'une de deux façons entre le noeud de mémorisation 206, 210 correspondant et le noeud intermédiaire 208, 212 correspondant. Dans le cas d'un élément STT, l'orientation est déterminée par l'ordre d'une couche fixe et d'une couche de mémorisation, comme cela va être décrit plus en détail ci-après. Les éléments 202, 204 sont tous deux par exemple orientés de la même façon entre ces noeuds correspondants, par exemple chacun ayant sa couche fixe située la plus proche du noeud de mémorisation 206, 210 correspondant, de sorte qu'ils ont des orientations opposées par rapport à un courant d'écriture passant du noeud de mémorisation 206 vers le noeud de mémorisation 210 ou vice versa.

Comme cela est illustré en figure 4A, initialement les signaux AZ, WN1 et WN2 sont bas, et les signaux WP1 et WP2 sont haut, de sorte que les transistors 220 et 226 à 232 sont tous non conducteurs.

Le signal de données D_{NV} sur la ligne d'entrée 236 du circuit de commande 234 est par exemple d'abord mis à la valeur qui doit être programmée dans la cellule mémoire. Dans l'exemple de la figure 4A, la valeur est l'état logique "1" et le signal de données D_{NV} par exemple commence bas, et passe à une valeur haute sur un front montant 402.

Le signal de phase d'écriture WPH sur la ligne d'entrée 238 du circuit de commande 234 passe ensuite à l'état haut sur un front montant 404, lançant le début de la phase d'écriture. Cela déclenche, peu de temps après, un front montant du signal AZ, de sorte que le transistor 220 est activé, couplant entre eux les noeuds 208 et 212. En outre, peu de temps après, les signaux WP1, WN1, WP2 et WN2 sont mis à des valeurs appropriées pour provoquer le passage d'un courant dans les éléments résistifs 202 et 204 dans une direction qui va programmer leurs résistances conformément à la valeur de donnée "1" logique qui doit être programmée. Dans l'exemple de la figure 2, un état haut d'une valeur de donnée D_{NV} correspond à une valeur haute de la tension Q, en d'autres termes à une résistance Rₘᵢₙ de l'élément 202, et une résistance Rₘₐₓ de l'élément 204. Cela est par exemple obtenu en faisant passer un courant à partir du noeud de mémorisation 206, à travers les éléments résistifs 202 et 204, vers le noeud de mémorisation 210. Comme cela est représenté en figure 4A, cette direction de courant est générée en amenant le signal WP1 à l'état bas pour activer le transistor 226, et en amenant le signal WN2 à l'état haut pour activer le transistor 232.

Après que le courant a été appliqué pendant un temps suffisant pour établir les états résistifs des éléments 202 et 204, par exemple pendant une durée t_{W} comprise entre 0,1 ns et 20 ns, le signal WP1 est amené de nouveau à l'état haut, et le signal WN2 est amené à l'état bas, arrêtant le courant d'écriture. Les signaux AZ et WPH sont ensuite par exemple amenés à l'état bas, ce qui termine la phase d'écriture.

La figure 4B illustre un cas alternatif d'une phase d'écriture dans lequel la valeur de donnée à programmer est un état logigue "0", et ainsi le signal de donnée D_{NV} a un front descendant 406. Un front montant 408 du signal d'écriture déclenche ainsi un front montant du signal WN1 et un front descendant du signal WP2, afin de générer un courant à partir du noeud de mémorisation 210, à travers les éléments résistifs 204 et 202, vers le noeud de mémorisation 206, pendant une durée t_{W}. Cela programme une résistance Rₘᵢₙ de l'élément 202, et une résistance Rₘₐₓ de l'élément 204.

Les transistors 220 et 226 à 232 sont par exemple dimensionnés de telle sorte que le courant d'écriture généré par l'activation des transistors 226, 220 et 232, ou par l'activation des transistors 230, 220 et 228, soit suffisamment élevé pour programmer les états résistifs des éléments 202 et 204. En fonction du type et des dimensions des éléments résistifs 202, 204, un tel courant de programmation minimum serait par exemple de l'ordre de 20 µA à 1,5 mA. Au contraire, les transistors 214, 216 et 222, 224 sont par exemple dimensionnés de telle sorte que, pendant une phase de transfert lorsque le signal de transfert TR est activé, le niveau du courant passant dans les éléments résistifs 202 et 204 soit inférieur à celui nécessaire pour programmer leurs états résistifs, par exemple un niveau inférieur de 10 à 90 pourcent par rapport au courant d'écriture correspondant.

En référence à la figure 1 décrite précédemment, pendant une phase d'écriture des dispositifs MTJ, le transistor MN7 est nécessaire afin de déconnecter le noeud 102 de la masse, et ainsi éviter que le courant d'écriture ne s'écoule vers la masse. Toutefois, comme cela a été décrit précédemment, le transistor 219 entre le noeud 218 et la masse dans la cellule mémoire 200 peut être supprimé. En effet, puisque les transistors 214 et 216 formant un registre sont situés entre les noeuds de mémorisation 206, 210 et la masse, le courant d'écriture va encore s'écouler à travers les éléments résistifs même si le noeud 218 est couplé à la masse pendant la phase d'écriture.

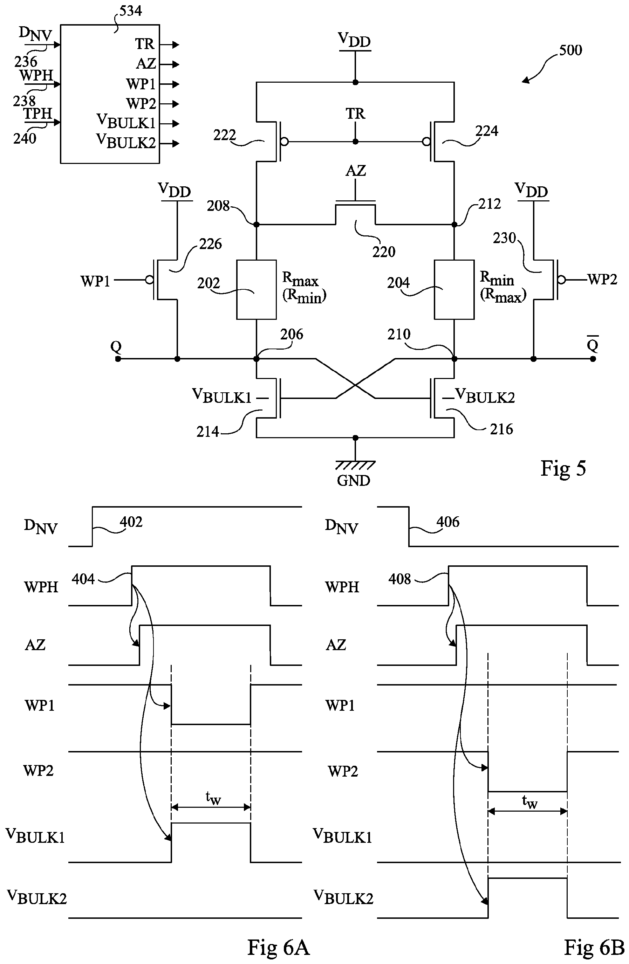

La figure 5 illustre une cellule mémoire 500 selon une variante de réalisation par rapport à la cellule mémoire 200 de la figure 2. De nombreux éléments de la cellule mémoire 500 sont identiques à ceux de la cellule mémoire 200, et ces éléments portent les mêmes références numériques et seront pas décrits de nouveau en détail. La différence dans la mémoire 500 est que les transistors 228 et 232 ont été supprimés. En outre, des noeuds de tension de substrat des transistors 214 et 216 sont illustrés en figure 5. Le circuit de commande 234 est aussi remplacé dans la cellule mémoire 500 par un circuit de commande 534, qui ne fournit plus les signaux de commande WN1 et WN2, et fournit optionnellement des niveaux de tension de substrat V_{BULK2} et B_{BULK1}, qui sont appliqués aux noeuds de tension de substrat des transistors 214 et 216 respectivement, comme on va le décrire plus en détail ci-après.

Une phase de transfert peut être mise en oeuvre dans le circuit 500 de la même façon que celle décrite précédemment en relation avec les figures 3A et 3B, et ne va pas être décrite de nouveau en détail.

Le fonctionnement de la cellule mémoire 500 pendant une phase d'écriture va maintenant être décrit en faisant référence aux figures 6A et 6B.

Les figures 6A et 6B illustrent des exemples de chronogrammes des signaux D_{NV}, WPH, AZ, WP1, WP2, B_{BULK1} et V_{BULK2} dans le circuit de la figure 5 pendant une phase d'écriture des états résistifs des éléments résistifs 202 et 204. Les signaux D_{NV}, WPH, AZ, WP1 et WP2 sont les mêmes que ceux des figures 4A et 4B, et ne vont pas être décrits de nouveau en détail.

Dans l'exemple de la figure 6A, le courant d'écriture est généré en activant seulement les transistors 220 et 226. Le courant d'écriture circule ainsi à partir du noeud de mémorisation 206, à travers les éléments résistifs 202 et 204, vers le noeud de mémorisation 210. Le noeud 206 étant à une tension relativement élevée, le transistor 216 est conducteur, et ainsi le courant d'écriture passe vers la masse par l'intermédiaire du transistor 216.

De façon similaire, dans l'exemple de la figure 6B, le courant d'écriture est généré en activant seulement les transistors 220 et 230. Le courant d'écriture circule ainsi à partir du noeud de mémorisation 210, à travers les éléments résistifs 204 et 202, vers le noeud de mémorisation 206. Le noeud 210 étant à une tension relativement élevée, le transistor 214 est conducteur, et ainsi le courant d'écriture circule vers la masse par l'intermédiaire du transistor 214.

Ainsi, la cellule mémoire 500 de la figure 5 comprend seulement sept transistors.

La commande des tensions de substrat V_{BULK1} et V_{BULK2} des transistors 214 et 216 peut être utilisée pour augmenter le courant d'écriture, comme on va le décrire maintenant.

En faisant de nouveau référence aux figures 6A et 6B, les tensions de substrat V_{BULK1} et V_{BULK2} appliquées aux transistors 214 et 216 respectivement sont par exemple à la masse, excepté pendant la phase d'écriture. Pendant la phase d'écriture, la tension de substrat de l'un des transistors est commutée sur un niveau de tension supérieur à la masse, par exemple à la tension d'alimentation V_{DD}, au moins pendant la période d'écriture t_{W}.

Dans l'exemple de la figure 6A, le courant d'écriture circule à partir du noeud de mémorisation 206 vers le noeud de mémorisation 210. Par conséquent, la tension de substrat V_{BULK1} du transistor 214 est augmentée pour réduire le courant de fuite passant vers la masse par l'intermédiaire du transistor 214. La tension de substrat V_{BULK2} du transistor 216 reste toutefois basse, de sorte que le transistor 216 reste complètement conducteur.

Dans l'exemple de la figure 6B, le courant d'écriture passe du noeud de mémorisation 210 vers le noeud de mémorisation 206. Par conséquent, la tension de substrat V_{BULK2} du transistor 216 est augmentée pour réduire le courant de fuite passant vers la masse par l'intermédiaire du transistor 216. La tension de substrat V_{BULK1} du transistor 214 reste toutefois faible, de sorte que le transistor 214 reste complètement conducteur.

Il sera clair pour l'homme de l'art qu'une commande de tension de substrat similaire pourrait aussi être appliquée de la même manière dans la cellule mémoire 200 de la figure 2. Toutefois, dans le mode de réalisation de la figure 2, dans lequel un chemin de conduction séparé est prévu entre chacun des noeuds de mémorisation 206, 210 et la masse, les tensions de substrat des deux transistors 214 et 216 sont par exemple contrôlées par un seul signal de commande V_{BULK}, qui est par exemple augmenté pendant la phase d'écriture.

Les figures 7A et 7B illustrent les structures d'éléments résistifs à couple de transfert de spin (STT) selon des exemples de réalisation. Par exemple, chacun des éléments résistifs 202 et/ou 204 décrits ici a une structure correspondant à celle de la figure 7A ou 7B. A titre de variante, comme cela a été mentionné précédemment, les éléments résistifs pourraient être des éléments de mémoire RAM RedOx, des éléments FeRAM, des éléments PCRAM, ou d'autres types d'éléments résistifs ayant une résistance programmable par la direction d'un flux de courant.

La figure 7A illustre un élément résistif STT 700 ayant une anisotropie magnétique dans le plan. L'élément 700 est par exemple sensiblement cylindrique, mais a une section qui est non circulaire, par exemple ovale, ce qui conduit par exemple à une augmentation de la stabilité de rétention des états résistifs lorsque le dispositif est programmé.

L'élément 700 comprend des électrodes inférieure et supérieure, 702 et 704, chacune ayant sensiblement une forme de disque, et prenant en sandwich entre elles un certain nombre de couches intermédiaires. Les couches intermédiaires comprennent, du bas vers le haut, une couche fixe 706, une barrière d'oxydation 708, et une couche de mémorisation 710.

La barrière d'oxydation 708 est par exemple en MgO ou en AlₓO_{y}. La couche fixe 706 et la couche de mémorisation 710 sont par exemple en matériau ferromagnétique, tel que du CoFe. La direction de spin dans la couche fixe 706 est fixe, comme cela est représenté par une flèche de la gauche vers la droite en figure 7A. Bien sûr, dans des variantes de réalisation, la direction de spin pourrait être de la droite vers la gauche dans la couche fixe 706. Toutefois, la direction de spin dans la couche de mémorisation 710 peut être changée, comme cela est représenté par des flèches dans des directions opposées en figure 7A. La direction de spin est programmée par la direction du courant d'écriture I qui passe dans l'élément, de sorte que la direction de spin dans la couche de mémorisation soit parallèle, en d'autres termes dans la même direction, ou est anti-parallèle, en d'autres termes, dans la direction opposée, par rapport à la couche fixe 706.

La figure 7B illustre un élément résistif STT 720 avec une anisotropie magnétique perpendiculaire au plan. Un tel élément résistif peut par exemple être programmé par un courant d'écriture I plus petit que pour l'élément 700 pour une taille donnée et/ou pour un volume de couche de mémorisation donné. Un tel élément est par conséquent par exemple utilisé dans la cellule mémoire 500 de la figure 5, où un courant d'écriture relativement faible est souhaitable.

L'élément 720 est sensiblement cylindrique, et par exemple a une section qui est circulaire. L'élément 720 comprend des électrodes inférieure et supérieure 722 et 724, chacune ayant sensiblement une forme de disque et prenant en sandwich un certain nombre de couches intermédiaires. Les couches intermédiaires comprennent, du bas vers le haut, une couche fixe 726, une barrière d'oxydation 728, et une couche de mémorisation 730. Ces couches sont similaires aux couches correspondantes 706, 708 et 710 de l'élément 700, excepté que la couche fixe 726 et la couche de mémorisation 730 ont une anisotropie perpendiculaire au plan, comme cela est représenté par les flèches verticales dans les couches 726 et 730 de la figure 7B. La couche fixe 726 est illustrée comme ayant une direction de spin du bas vers le haut en figure 7B, mais bien sûr, dans des variantes de réalisation, cette direction de spin pourrait être du haut vers le bas.

Si les éléments STT 700 ou 720 de la figure 7A ou 7B sont utilisés pour mettre en oeuvre chacun des éléments résistifs 202, 204 décrits ici, leur orientation peut par exemple être choisie de façon à minimiser le niveau de courant d'écriture permettant de les programmer. En particulier, en fonction de facteurs tels que les dimensions des éléments 202, 204, on peut obtenir un courant d'écriture faible lorsque chaque élément a son électrode inférieure 702, 722 connectée au noeud de mémorisation correspondant 206, 210, mais l'inverse peut être vrai aussi.

La figure 8 illustre une cellule mémoire 800 selon une variante de réalisation par rapport aux figures 2 et 5. De nombreux éléments sont les mêmes que ceux des figures 2 et 5, et ces éléments ne vont pas être décrits en détail. La différence dans le circuit de la figure 8 est que des transistors NMOS sont remplacés par des PMOS, et vice-versa. En particulier, les transistors NMOS 214 et 216 ont été remplacés par des transistors PMOS 814 et 816. En outre, le noeud 218 est connecté à la tension d'alimentation V_{DD}, ou couplé à la tension d'alimentation V_{DD}, par l'intermédiaire d'un transistor PMOS 819 optionnel. En outre, les transistors PMOS 222 et 224 ont été remplacés par des transistors NMOS 822 et 824 couplés à la masse. Les transistors PMOS 226 et 230 ont été remplacés par des transistors NMOS 826 et 830 couplés à la masse, tandis que les transistors NMOS 228 et 232 ont été remplacés par des transistors PMOS 828 et 832, qui sont optionnels puisqu'ils peuvent être supprimés comme dans l'exemple de la figure 5.

Il sera clair pour l'homme de l'art que le fonctionnement de la cellule mémoire de la figure 8 est sensiblement similaire à celui des cellules mémoires des figures 2 et 5, la seule différence étant les inversions de tension normale résultant de l'échange NMOS/PMOS. Pour faciliter l'illustration, un circuit de commande basé sur le circuit de commande 234 ou 534 des figures 2 et 5, n'est pas illustré en figure 8. En outre, bien que cela ne soit pas représenté en figure 8, la tension de substrat de l'un des transistors 814, 816, qui est par exemple normalement à la tension d'alimentation V_{DD}, pourrait être amenée à une valeur inférieure, par exemple la masse, pendant une phase d'écriture, comme dans le procédé décrit précédemment en relation avec la figure 5.

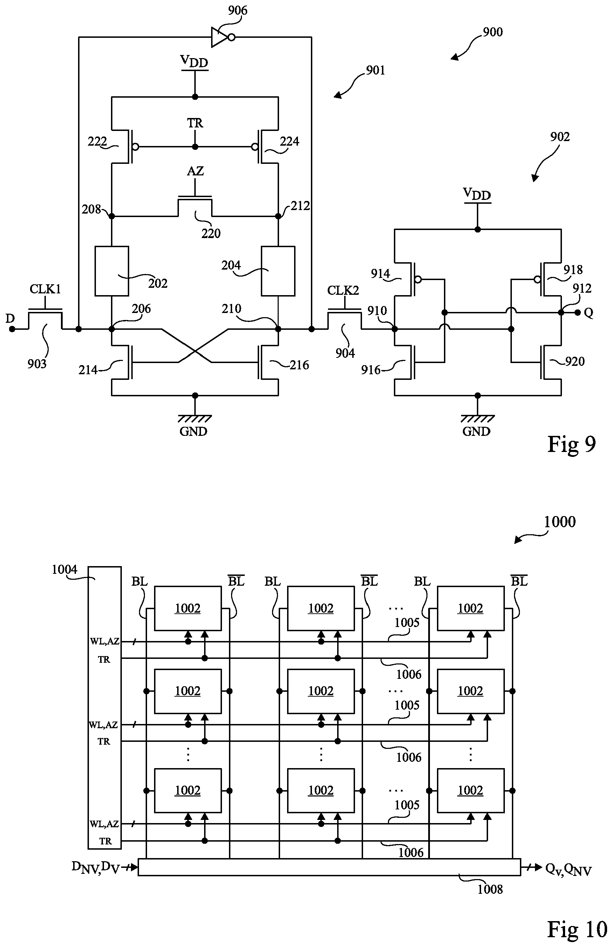

La figure 9 illustre un dispositif mémoire synchrone 900 comprenant une cellule mémoire 901 basée sur le circuit des figures 2 et 5, selon un exemple de réalisation. Bien sûr, la cellule mémoire 901 pourrait également être basée sur le circuit de la figure 8. Pour faciliter l'illustration, les deux ou quatre transistors utilisés pour générer le courant d'écriture pour programmer les éléments résistifs 202, 204 n'ont pas été illustrés en figure 9, et il en est de même pour le circuit de commande 234 ou 534.

Le dispositif mémoire synchrone 900 de la figure 9 est une bascule, et en particulier une bascule D. Toutefois, il sera clair pour l'homme de l'art que d'autres types de dispositifs mémoires synchrones pourraient aussi être mis en oeuvre sur la base des mêmes principes.

La cellule mémoire 901 forme un registre maître, et une autre cellule mémoire 902 forme un registre esclave, couplé en série avec la cellule mémoire 901. Le noeud de mémorisation 206 de la cellule mémoire 901 est couplé à l'entrée du dispositif mémoire synchrone par l'intermédiaire des noeuds de courant principaux d'un transistor NMOS 903, qui reçoit sur son noeud de commande un signal d'horloge CLK1. Le noeud de mémorisation 206 est en outre couplé au noeud de mémorisation 210 de la cellule mémoire 901 par l'intermédiaire d'un inverseur 906. Le noeud de mémorisation 210 est couplé à la cellule mémoire 902 par l'intermédiaire des noeuds de courant principaux d'un autre transisor NMOS 904, qui reçoit sur son noeud de commande un signal d'horloge CLK2.

La cellule mémoire 902 comprend un noeud de mémorisation 910 couplé au transistor 904, et un autre noeud de mémorisation 912. Deux inverseurs sont couplés de façon croisée entre les noeuds de mémorisation 910 et 912, un inverseur étant formé par un transistor PMOS 914 et un transistor NMOS 916 couplés en série entre V_{DD} et la masse, et l'autre inverseur étant formé par un transistor PMOS 918 et un transistor NMOS 920 couplés en série entre V_{DD} et la masse. Les noeuds de commande des transistors 914 et 916 sont couplés au noeud de mémorisation 912, et les noeuds de commande des transistors 918 et 920 sont couplés au noeud de mémorisation 910. Le noeud de mémorisation 912 fournit un signal de sortie Q du dispositif mémoire synchrone 900.

En fonctionnement, quelque soit les états résistifs programmés des éléments résistifs 202 et 204, le dispositif mémoire synchrone 900 peut fonctionner comme une bascule standard, mémorisant des données sur ses noeuds de mémorisation 206, 210 et 910, 912 de manière volatile, sur la base de données d'entrée présentées au niveau du noeud d'entrée. En particulier, sur un front montant du signal d'horloge CLK1, la donnée d'entrée D est mémorisée sur le noeud de mémorisation 206 et son inverse est mémorisé sur le noeud 210 de la cellule mémoire 901. Ensuite, sur un front montant du signal d'horloge CLK2, la donnée sur le noeud de mémorisation 210 est mémorisée sur le noeud de mémorisation 910, et son inverse est mémorisé sur le noeud de mémorisation 912, de sorte que la sortie Q devient égale à la donnée d'entrée D.

En outre, des données peuvent être mémorisées de manière non volatile en programmant les états résistifs des éléments résistifs 202 et 204, comme cela a été décrit précédemment. Ces données peuvent aussi être transférées vers les noeuds de mémorisation 206 et 210 en activant, pendant que les signaux d'horloge CLK1 et CLK2 sont bas, les transistors 222 et 224 pendant une phase de transfert comme décrit précédemment, et les données deviennent ensuite accessibles sur la sortie Q de la bascule 900 après le front d'horloge montant suivant. Il sera clair pour l'homme de l'art que dans des variantes de réalisation, les positions des circuits 901 et 902 de la figure 9 pourraient être interverties, le circuit 902 formant le registre maître et le circuit 901 formant le registre esclave.

La figure 10 illustre un réseau mémoire 1000 comprenant un réseau de cellules mémoires 1002. Dans l'exemple de la figure 10, il y a neuf cellules mémoires 1002 agencées en trois rangées et trois colonnes. Toutefois, il ne pourrait y avoir que deux rangées et/ou deux colonnes, ou, comme cela est représenté par des lignes en pointillés en figure 10, il pourrait y avoir plus que trois rangées et/ou plus que trois colonnes.

Chaque cellule mémoire 1002 correspond par exemple sensiblement à la cellule mémoire des figures 5 ou 8, décrite précédemment. Toutefois, plutôt que d'être couplés à la tension d'alimentation V_{DD}, les transistors 226 et 230 de la cellule mémoire de la figure 5, ou les transistors 826 et 830 de la cellule mémoire de la figure 8, sont couplés à des lignes de bits BL et BL respectivement. En outre, ces transistors sont tous les deux contrôlés par le même signal de ligne de mot WL décrit plus en détail ci-après. En variante, les noeuds de mémorisation 206, 210 pourraient être connectés directement aux lignes de bit BL et B̅L̅ respectivement, ou couplés aux lignes de bit BL et B̅L̅ respectivement par l'intermédiaire de transistors additionnels. En outre, le circuit de commande 534 de chaque cellule mémoire a été remplacé par des blocs de commande de rangées et de colonnes communs, comme on va le décrire maintenant.

Un bloc de commande de rangée 1004 fournit des signaux de commande sur des lignes de rangée 1005 allant vers les cellules mémoires, un groupe de lignes de rangée commun 1005 étant prévu pour chaque rangée. Par exemple, chaque groupe de lignes de rangée 1005 comprend le signal de ligne de mot WL pour contrôler les transistors 226 et 230 de la cellule mémoire 500 de la figure 5, ou les transistors 826 et 830 de la cellule mémoire 800 de la figure 8. En outre, ce groupe de lignes de rangée 1005 comprend par exemple le signal AZ pour contrôler le transistor 220 de chaque cellule mémoire. Le bloc de commande de rangée 1004 fournit aussi par exemple le signal de transfert TR à chaque cellule mémoire sur une ligne de rangée 1006 correspondante, une ligne de rangée 1006 commune étant prévue pour les cellules mémoires de chaque rangée. Les signaux de transfert commandent les transistors 222, 224 de la cellule mémoire 500, ou les transistors 822, 824 de la cellule mémoire 800.

Un bloc de commande de colonne 1008 reçoit par exemple les données D_{V} à mémoriser de manière volatile par une rangée de cellules mémoires pendant une opération d'écriture standard, et les données D_{NV} à mémoriser de manière non volatile par chacune des cellules mémoires pendant une phase d'écriture des éléments résistifs 202, 204 de chaque cellule mémoire 1002. Le bloc de commande de colonne 1008 est couplé à chacune des lignes de bit BL et B̅L̅.

En fonctionnement, pendant une phase d'écriture des éléments résistifs 202, 204 dans chacune des cellules mémoires 1002, une seule rangée de cellules mémoires est programmée à la fois. La programmation est par exemple réalisée en activant le signal de ligne de mot WL et le signal AZ de chacune des cellules mémoires de la rangée à programmer, pour activer les transistors correspondants 220, 226 et 230, ou 220, 826 et 830. Cela crée un chemin de conduction entre les lignes de bit BL et B̅L̅ de chaque colonne, passant à travers les éléments résistifs 202, 204 de chaque cellule mémoire. La ligne de bit BL ou B̅L̅ de chaque colonne est ensuite couplée sélectivement à la tension d'alimentation V_{DD} pour générer le courant d'écriture dans une direction dépendant de la donnée D_{NV} à programmer.

Pour mettre en oeuvre une phase de transfert telle que la donnée mémorisée par les éléments résistifs 202, 204 soit transférée vers les noeuds de mémorisation 206, 210, le signal de transfert TR et le signal AZ sont activés comme cela a été décrit précédemment en relation avec les figures 3A et 3B, et cette opération peut être réalisée dans toutes les cellules mémoires 1002 à la fois. Les données peuvent ensuite être lues dans chaque cellule mémoire rangée par rangée d'une manière standard.

En plus de la mémorisation de données de manière non volatile, des données peuvent être mémorisées de manière volatile dans chaque cellule mémoire de la même façon que dans une mémoire RAM.

Avec la description ainsi faite de plusieurs modes de réalisation illustratifs, diverses altérations, modifications et améliorations apparaîtront facilement à l'homme de l'art.

Par exemple, il sera clair pour l'homme de l'art que la tension d'alimentation V_{DD} dans les divers modes de réalisation pourrait avoir un niveau quelconque, par exemple entre 1 et 3 V, plutôt que d'être à 0 V, et que la tension de masse peut aussi être considérée comme étant une tension d'alimentation qui pourrait être à un niveau quelconque, comme un niveau négatif.

En outre, il sera clair pour l'homme de l'art que, dans tous les modes de réalisation décrits ici, tous les transistors NMOS pourraient être remplacés par des transistors PMOS, et/ou tous les transistors PMOS pourraient être remplacés par des transistors NMOS. L'homme de l'art saura comment tous les circuits peuvent être mis en oeuvre en utilisant uniquement des transistors PMOS ou uniquement des transistors NMOS. En outre, bien qu'on ait décrit ici des transistors basés sur la technologie MOS, dans des variantes de réalisation on pourrait utiliser d'autres technologies de transistors, comme la technologie bipolaire.

## Revendications

1. Cellule mémoire comprenant :
des premier et deuxième éléments résistifs (202, 204), au moins l'un d'eux étant programmable pour prendre l'un d'au moins deux états résistifs (Rₘᵢₙ, Rₘₐₓ), une valeur de donnée étant représentée par les résistances relatives des premier et deuxième éléments résistifs, le premier élément résistif (202) étant couplé entre un premier noeud de mémorisation (206) et un premier noeud intermédiaire (208), le deuxième élément résistif (204) étant couplé entre un deuxième noeud de mémorisation (210) et un deuxième noeud intermédiaire (212) ;
un premier transistor (214) couplé entre le premier noeud de mémorisation et une première tension d'alimentation (GND, V_{DD});
un deuxième transistor (216) couplé entre le deuxième noeud de mémorisation et la première tension d'alimentation, un noeud de commande du premier transistor étant couplé au deuxième noeud de mémorisation et un noeud de commande du deuxième transistor étant couplé au premier noeud de mémorisation ;
un troisième transistor (220) couplé entre les premier et deuxième noeuds intermédiaires ; **caractérisée par**
un quatrième transistor (226, 826) connecté entre le premier noeud de mémorisation (206) et une deuxième tension d'alimentation (V_{DD}, GND) ;
un cinquième transistor (230, 830) connecté entre le deuxième noeud de mémorisation (208) et la deuxième tension d'alimentation ; et
un circuit de commande (226 à 234, 826 à 834) agencé pour activer le troisième transistor pendant l'application, par l'activation du quatrième ou cinquième transistor, de la deuxième tension d'alimentation (V_{DD}, GND) au premier ou au deuxième noeud de mémorisation pour générer un courant de programmation dans une direction sélectionnée à travers les premier et deuxième éléments résistifs pour programmer l'état résistif d'au moins l'un desdits éléments.

2. Cellule mémoire selon la revendication 1, dans laquelle chacun des premier et deuxième transistors (214, 216) est connecté à la première tension d'alimentation.

3. Cellule mémoire selon la revendication 1 ou 2, dans laquelle au moins l'un des premier et deuxième éléments résistifs est l'un des éléments suivants :
un élément à couple de transfert de spin ayant une anisotropie dans le plan ;
un élément à couple de transfert de spin ayant une anisotropie perpendiculaire au plan ;
un élément à oxydoréduction (RedOx) ;
un élément ferro-électrique ; et
un élément à changement de phase.

4. Cellule mémoire selon l'une quelconque des revendications 1 à 3, dans laquelle chacun des premier et deuxième transistors comprend un noeud de substrat, et dans lequel le circuit de commande est en outre agencé pour coupler le noeud de substrat d'au moins l'un des premier et deuxième transistors à la première tension d'alimentation et le noeud de substrat de l'autre des premier et deuxième transistors à une troisième tension d'alimentation différente de la première tension d'alimentation pendant l'application de la deuxième tension d'alimentation (V_{DD}, GND) au premier ou au deuxième noeud de mémorisation.

5. Cellule mémoire selon la revendication 4, dans laquelle la troisième tension d'alimentation est égale à la deuxième tension d'alimentation.

6. Cellule mémoire selon l'une quelconque des revendications 1 à 5, comprenant en outre :
un sixième transistor (222) couplé entre le premier noeud intermédiaire et la deuxième tension d'alimentation ; et
un septième transistor (224) couplé entre le deuxième noeud intermédiaire et la deuxième tension d'alimentation.

7. Cellule mémoire selon la revendication 6, dans laquelle le circuit de commande est en outre agencé pour transférer la valeur de donnée représentée par les états résistifs des premier et deuxième éléments résistifs vers les premier et deuxième noeuds de mémorisation en activant les sixième et septième transistors.

8. Cellule mémoire selon la revendication 6 ou 7, dans laquelle les sixième et septième transistors sont adaptés à avoir une tension de seuil inférieure à celle des premier et deuxième transistors.

9. Cellule mémoire selon l'une quelconque des revendications 1 à 7, dans laquelle les quatrième et cinquième transistors sont adaptés à avoir une tension de seuil inférieure à celle des premier et deuxième transistors.

10. Dispositif mémoire comprenant :
un réseau de cellules mémoires, chaque cellule mémoire comprenant la cellule mémoire de l'une quelconque des revendications 1 à 9.

11. Dispositif mémoire selon la revendication 10, dans lequel les premiers noeuds de mémorisation des cellules mémoires sont couplés à des premières lignes de bit (BL) du dispositif mémoire et les deuxièmes noeuds de mémorisation des cellules mémoires sont couplés à des deuxièmes lignes de bit (B̅L̅) du dispositif mémoire.

12. Dispositif mémoire selon la revendication 11, dans lequel le premier noeud de mémorisation de chacune des cellules mémoires est couplé à l'une correspondante des premières lignes de bit (BL) par l'intermédiaire d'un huitième transistor (502), et le deuxième noeud de mémorisation de chacune des cellules mémoires est couplé à l'une correspondante des deuxièmes lignes de bit (B̅L̅) par l'intermédiaire d'un neuvième transistor (902).

13. Dispositif mémoire synchrone comprenant :
la cellule mémoire de l'une quelconque des revendications 1 à 9 ; et
une autre cellule mémoire couplée en série avec ladite cellule mémoire par l'intermédiaire d'un dixième transistor (904), l'autre cellule mémoire comprenant deux inverseurs couplés de façon croisée.

14. Procédé de mémorisation non volatile d'une valeur de donnée dans une cellule mémoire, la cellule mémoire comprenant : des premier et deuxième éléments résistifs dont au moins l'un est programmable pour prendre l'un d'au moins deux états résistifs (Rₘᵢₙ, Rₘₐₓ), le premier élément résistif (202) étant couplé entre un premier noeud de mémorisation (206) et un premier noeud intermédiaire (208), le deuxième élément résistif (204) étant couplé entre un deuxième noeud de mémorisation (210) et un deuxième noeud intermédiaire (212) ; un premier transistor (214) couplé entre le premier noeud de mémorisation et une première tension d'alimentation (GND, V_{DD}) ; un deuxième transistor (216) couplé entre le deuxième noeud de mémorisation et la première tension d'alimentation, un noeud de commande du premier transistor étant couplé au deuxième noeud de mémorisation et un noeud de commande du deuxième transistor étant couplé au premier noeud de mémorisation ; un troisième transistor (220) couplé entre les premier et deuxième noeuds intermédiaires ; **caractérisé par** un quatrième transistor (226, 826) connecté entre le premier noeud de mémorisation (206) et une deuxième tension d'alimentation (V_{DD}, GND) ; et un cinquième transistor (230, 830) connecté entre le deuxième noeud de mémorisation (208) et la deuxième tension d'alimentation ; le procédé comprenant :
activer le troisième transistor (220) ;
appliquer la deuxième tension d'alimentation (V_{DD}, GND), par l'activation du quatrième ou cinquième transistor, au premier ou au deuxième noeud de mémorisation pendant que le troisième transistor est activé pour générer un courant de programmation dans une direction sélectionnée à travers les premier et deuxième éléments résistifs pour programmer l'état résistif d'au moins l'un desdits éléments, la valeur de donnée étant représentée par les résistances relatives des premier et deuxième éléments résistifs.

## Patentansprüche

1. Speicherzelle, die Folgendes aufweist:
erste und zweite Widerstandselemente (202, 204), von denen wenigstens eines programmierbar ist, um einen von wenigstens zwei Widerstandszuständen (Rₘᵢₙ, Rₘₐₓ) zu haben, wobei ein Datenwert durch die relativen Widerstände der ersten und zweiten Widerstandselemente dargestellt wird, wobei das erste Widerstandselement (202) zwischen einem ersten Speicherknoten (206) und einem ersten Zwischenknoten (208) gekoppelt ist, wobei das zweite Widerstandselement (204) zwischen einem zweiten Speicherknoten (210) und einem zweiten Zwischenknoten (212) gekoppelt ist;
einen ersten Transistor (214), der zwischen dem ersten Speicherknoten und einer ersten Versorgungsspannung (G_{ND}, V_{DD}) gekoppelt ist;
einen zweiten Transistor (216), der zwischen dem zweiten Speicherknoten und der ersten Versorgungsspannung gekoppelt ist, wobei ein Steuerknoten des ersten Transistors mit dem zweiten Speicherknoten gekoppelt ist und ein Steuerknoten des zweiten Transistors mit dem ersten Speicherknoten gekoppelt ist;
einen dritten Transistor (220), der zwischen den ersten und zweiten Zwischenknoten gekoppelt ist; **gekennzeichnet durch**:
einen vierten Transistor (226, 826), der zwischen dem ersten Speicherknoten (206) und einer zweiten Versorgungsspannung (V_{DD}, G_{ND}) verbunden ist;
einen fünften Transistor (230, 830), der zwischen dem zweiten Speicherknoten (208) und der zweiten Versorgungsspannung verbunden ist; und
Steuerschaltung (226 bis 234, 826 bis 834), die konfiguriert ist, um den dritten Transistor zu aktivieren, während sie durch Aktivieren des vierten oder fünften Transistors die zweite Versorgungsspannung (V_{DD}, G_{ND}) an den ersten oder zweiten Speicherknoten anlegt, um einen Programmierstrom in einer ausgewählten Richtung durch die ersten und zweiten Widerstandselemente zu erzeugen, um den Widerstandszustand von wenigstens einem der Elemente zu programmieren.

2. Speicherzelle nach Anspruch 1, wobei jeder der ersten und zweiten Transistoren (214, 216) mit der ersten Versorgungsspannung verbunden ist.

3. Speicherzelle nach Anspruch 1 oder 2, wobei wenigstens eines der ersten und zweiten Widerstandselemente eines der Folgenden ist:
ein Spin-Transfer-Torque-Element mit In-Ebene-Anisotropie;
ein Spin-Transfer-Torque-Element mit senkrecht zur Ebene stehender Anisotropie;
ein Reduktionsoxid (RedOx)-Element;
ein ferroelektrisches Element; und
ein Phasenänderungselement.

4. Speicherzelle nach einem der Ansprüche 1 bis 3, wobei jeder der ersten und zweiten Transistoren einen Hauptknoten aufweist, und wobei die Steuerschaltung ferner konfiguriert ist, um den Hauptknoten von wenigstens einem der ersten und zweiten Transistoren mit der ersten Versorgungsspannung und den Hauptknoten des anderen der ersten und zweiten Transistoren mit einer dritten Versorgungsspannung zu koppeln, die sich von der ersten Versorgungsspannung unterscheidet, während die zweite Versorgungsspannung (V_{DD}, G_{ND}) an den ersten oder zweiten Speicherknoten angelegt wird.

5. Speicherzelle nach Anspruch 4, wobei die dritte Versorgungsspannung gleich der zweiten Versorgungsspannung ist.

6. Speicherzelle nach einem der Ansprüche 1 bis 5, die ferner Folgendes aufweist:
einen sechsten Transistor (222), der zwischen dem ersten Zwischenknoten und der zweiten Versorgungsspannung gekoppelt ist; und
einen siebten Transistor (224), der zwischen dem zweiten Zwischenknoten und der zweiten Versorgungsspannung gekoppelt ist.

7. Speicherzelle nach Anspruch 6, wobei die Steuerschaltung ferner konfiguriert ist, um den Datenwert, der durch die Widerstandszustände der ersten und zweiten Widerstandselemente dargestellt wird, an die ersten und zweiten Speicherknoten durch Aktivieren der sechsten und siebten Transistoren zu übertragen.

8. Speicherzelle nach Anspruch 6 oder 7, wobei die sechsten und siebten Transistoren geeignet sind, eine niedrigere Schwellenspannung als die ersten und zweiten Transistoren aufzuweisen.

9. Speicherzelle nach einem der Ansprüche 1 bis 7, wobei die vierten und fünften Transistoren geeignet sind, eine niedrigere Schwellenspannung als die ersten und zweiten Transistoren aufzuweisen.

10. Speichervorrichtung, die Folgendes aufweist:
eine Anordnung der Speicherzellen, wobei jede Speicherzelle die Speicherzelle nach einem der Ansprüche 1 bis 9 aufweist.

11. Speichervorrichtung nach Anspruch 10, wobei die ersten Speicherknoten der Speicherzellen mit ersten Bitlinien (BL) der Speichervorrichtung und die zweiten Speicherknoten der Speicherzellen mit zweiten Bitlinien (B̅L̅) der Speichervorrichtung gekoppelt sind.

12. Speichervorrichtung nach Anspruch 11, wobei der erste Speicherknoten jeder der Speicherzellen über einen achten Transistor (502) mit einer entsprechenden der ersten Bitlinien (BL) und der zweite Speicherknoten jeder der Speicherzellen mit einer entsprechenden der zweiten Bitlinien (B̅L̅) über einen neunten Transistor (902) gekoppelt ist.

13. Synchrone Speichervorrichtung, die Folgendes aufweist:
die Speicherzelle nach einem der Ansprüche 1 bis 9; und
eine weitere Speicherzelle, die über einen zehnten Transistor (904) in Reihe mit der Speicherzelle gekoppelt ist, wobei die weitere Speicherzelle ein Paar über Kreuz gekoppelter Inverter aufweist.

14. Verfahren zum nichtflüchtigen Speichern eines Datenwerts in einer Speicherzelle, wobei die Speicherzelle Folgendes aufweist: erste und zweite Widerstandselemente, von denen wenigstens eines programmierbar ist, um einen von wenigstens zwei Widerstandszuständen (Rₘᵢₙ, Rₘₐₓ) zu haben, wobei das erste Widerstandselement (202) zwischen einem ersten Speicherknoten (206) und einem ersten Zwischenknoten (208) gekoppelt ist, wobei das zweite Widerstandselement (204) zwischen einem zweiten Speicherknoten (210) und einem zweiten Zwischenknoten (212) gekoppelt ist; einen ersten Transistor (214), der zwischen dem ersten Speicherknoten und einer ersten Versorgungsspannung (GND, VDD) gekoppelt ist; einen zweiten Transistor (216), der zwischen dem zweiten Speicherknoten und der ersten Versorgungsspannung gekoppelt ist, wobei ein Steuerknoten des ersten Transistors mit dem zweiten Speicherknoten gekoppelt ist und ein Steuerknoten des zweiten Transistors mit dem ersten Speicherknoten gekoppelt ist; einen dritten Transistor (220), der zwischen dem ersten und zweiten Zwischenknoten gekoppelt ist; **gekennzeichnet durch**:
einen vierten Transistor (226, 826), der zwischen dem ersten Speicherknoten (206) und der zweiten Versorgungsspannung (V_{DD}, G_{ND}) verbunden ist; und einen fünften Transistor (230, 830), der zwischen dem zweiten Speicherknoten (208) und der zweiten Versorgungsspannung verbunden ist, wobei das Verfahren Folgendes aufweist:
Aktivieren des dritten Transistors (220);
Anlegen der zweiten Versorgungsspannung (V_{DD}, G_{ND}) durch Aktivieren des vierten oder fünften Transistors an den ersten oder zweiten Speicherknoten, während der dritte Transistor aktiviert ist, um einen Programmierstrom in einer ausgewählten Richtung durch das erste und zweite Widerstandselement zu erzeugen, um den Widerstandszustand von wenigstens einem der Elemente zu programmieren, wobei der Datenwert durch die relativen Widerstände der ersten und zweiten Widerstandselemente dargestellt wird.

## Claims

1. A memory cell comprising:
first and second resistive elements (202, 204), at least one of which is programmable to have one of at least two resistive states (Rₘᵢₙ, Rₘₐₓ), a data value being represented by the relative resistances of the first and second resistive elements, the first resistive element (202) being coupled between a first storage node (206) and a first intermediate node (208), the second resistive element (204) being coupled between a second storage node (210) and a second intermediate node (212);
a first transistor (214) coupled between said first storage node and a first supply voltage (GND, V_{DD});
a second transistor (216) coupled between said second storage node and said first supply voltage, wherein a control node of said first transistor is coupled to said second storage node and a control node of said second transistor is coupled to said first storage node;
a third transistor (220) coupled between the first and second intermediate nodes; **characterized by**:
a fourth transistor (226, 826) connected between the first storage node (206) and a second supply voltage (V_{DD}, GND);
a fifth transistor (230, 830) connected between the second storage node (208) and the second supply voltage; and
control circuitry (226 to 234, 826 to 834) configured to active said third transistor while applying, by activating the fourth or fifth transistor, the second supply voltage (V_{DD}, GND) to said first or second storage node to generate a programming current in a selected direction through said first and second resistive elements to program the resistive state of at least one of said elements.

2. The memory cell of claim 1, wherein each of said first and second transistors (214, 216) is connected to said first supply voltage.

3. The memory cell of claim 1 or 2, wherein at least one of said first and second resistive elements is one of:
a spin transfer torque element with in-plane anisotropy;
a spin transfer torque element with perpendicular-to-plane anisotropy;
a reduction oxide (RedOx) element;
a ferro-electric element; and
a phase change element.

4. The memory cell of any of claims 1 to 3, wherein each of said first and second transistors comprises a bulk node, and wherein said control circuitry is further configured to couple the bulk node of at least one of said first and second transistors to the first supply voltage and the bulk node of the other of the first and second transistors to a third supply voltage different from said first supply voltage while applying said second supply voltage (V_{DD}, GND) to said first or second storage node.

5. The memory cell of claim 4, wherein said third supply voltage is equal to said second supply voltage.

6. The memory cell of any of claims 1 to 5, further comprising:
a sixth transistor (222) coupled between said first intermediate node and said second supply voltage; and
a seventh transistor (224) coupled between said second intermediate node and said second supply voltage.

7. The memory cell of claim 6, wherein said control circuitry is further configured to transfer the data value represented by the resistive states of said first and second resistive elements to said first and second storage nodes by activating said sixth and seventh transistors.

8. The memory cell of claim 6 or 7, wherein said sixth and seventh transistors are adapted to have a lower threshold voltage than said first and second transistors.

9. The memory cell of any of claims 1 to 7, wherein the fourth and fifth transistors are adapted to have a lower threshold voltage than said first and second transistors.

10. A memory device comprising:
an array of the memory cells, each memory cell comprises the memory cell of any of claims 1 to 9.

11. The memory device of claim 10, wherein the first storage nodes of said memory cells are coupled to first bit lines (BL) of said memory device and the second storage nodes of said memory cells are coupled to second bit lines (B̅L̅) of said memory device.

12. The memory device of claim 11, wherein the first storage node of each of said memory cells is coupled to a corresponding one of said first bit lines (BL) via an eighth transistor (502), and the second storage node of each of said memory cells is coupled to a corresponding one of said second bit lines (B̅L̅) via a ninth transistor (902).

13. A synchronous memory device comprising:
the memory cell of any of claims 1 to 9; and
a further memory cell coupled in series with said memory cell via a tenth transistor (904), the further memory cell comprising a pair of cross-coupled inverters.

14. A method of non-volatile storage of a data value in a memory cell, the memory cell comprising: first and second resistive elements at least one of which is programmable to have one of at least two resistive states (Rₘᵢₙ, Rₘₐₓ), the first resistive element (202) being coupled between a first storage node (206) and a first intermediate node (208), the second resistive element (204) being coupled between a second storage node (210) and a second intermediate node (212); a first transistor (214) coupled between said first storage node and a first supply voltage (GND, V_{DD}); a second transistor (216) coupled between said second storage node and said first supply voltage, wherein a control node of said first transistor is coupled to said second storage node and a control node of said second transistor is coupled to said first storage node; a third transistor (220) coupled between the first and second intermediate nodes; **characterized by**:
a fourth transistor (226, 826) connected between the first storage node (206) and the second supply voltage (V_{DD}, GND); and a fifth transistor (230, 830) connected between the second storage node (208) and the second supply voltage, the method comprising:
activating said third transistor (220);
applying the second supply voltage (V_{DD}, GND), by activating the fourth or fifth transistor, to said first or second storage node while said third transistor is activated to generate a programming current in a selected direction through said first and second resistive elements to program the resistive state of at least one of said elements, the data value being represented by the relative resistances of the first and second resistive elements.
